(19) Europäisches Patentamt / European Patent Office / Office européen des brevets

(11) **EP 4 001 234 B1**

(12) **EUROPEAN PATENT SPECIFICATION**

(45) Date of publication and mention
of the grant of the patent:
**06.11.2024   Bulletin 2024/45**

(21) Application number: **20843535.4**

(22) Date of filing: **13.07.2020**

(51) International Patent Classification (IPC):
*C03C 27/12* (2006.01)     *H01R 12/51* (2011.01)
*H05B 3/02* (2006.01)     *H05B 3/16* (2006.01)
*H05B 3/20* (2006.01)     *H05B 3/86* (2006.01)
*B60J 1/00* (2006.01)     *H01R 4/02* (2006.01)
*H05K 3/12* (2006.01)     *B60S 1/02* (2006.01)
*C03C 17/00* (2006.01)

(52) Cooperative Patent Classification (CPC):
**B32B 17/10348; B32B 17/10036; B32B 17/10385;
C03C 17/008;** C03C 2217/479; H01R 4/02;
H01R 4/183; H01R 12/57; H05B 2203/003;
H05B 2203/013; H05B 2203/016; H05K 1/0212;
H05K 1/0306; H05K 3/12

(86) International application number:
**PCT/JP2020/027175**

(87) International publication number:
**WO 2021/015027 (28.01.2021 Gazette 2021/04)**

(54) **GLASS SHEET MODULE**

GLASSCHEIBENMODUL

MODULE DE PLAQUE DE VERRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.07.2019   JP 2019134188**

(43) Date of publication of application:
**25.05.2022   Bulletin 2022/21**

(60) Divisional application:
**24203033.6**

(73) Proprietor: **NIPPON SHEET GLASS COMPANY,
LIMITED
Tokyo 108-6321 (JP)**

(72) Inventor: **YANO, Yota
Tokyo 108-6321 (JP)**

(74) Representative: **Mewburn Ellis LLP
Aurora Building
Counterslip
Bristol BS1 6BX (GB)**

(56) References cited:
JP-A- 2000 012 201     JP-A- 2017 027 799
JP-A- 2017 130 402     JP-A- 2017 537 837
JP-A- 2018 020 771     JP-U- S63 129 309
US-A1- 2014 008 347     US-A1- 2017 041 987

**Description**

Technical Field

The present invention relates to a glass plate module.

Background Art

JP 2014-519149 A discloses a connection terminal to be connected to a conductive electricity supply portion formed on a glass plate of an automobile. A heating wire of a defogger or the like, or an antenna conductor is to be connected to this electricity supply portion. A wire such as a cable is connected to the connection terminal. Electricity is supplied from the electricity supply portion via the connection terminal, and thereby the heating wire heats the glass plate, or the antenna conductor receives electric power from the electricity supply portion and thus receives a radio wave. US 2017/0041987 A1 concerns a pane with an illuminated switch surface and a heating function. US 2014/0008347 A1 concerns a windowpane for vehicles including a glass sheet, a conductor layer which is formed on the surface of the glass sheet by sintering a silver paste containing a silver powder and a glass frit and which has at least a strip part and a terminal connection part connected to the strip part, and a connection terminal soldered onto the terminal connection part with a lead-free solder alloy, in which the conductor layer has a specific resistance of from 2.5 to 6.5 $\mu\Omega$cm, the strip part has a line width of not more than 0.35 mm, the lead-free solder alloy consists essentially of tin and silver and has a content of tin of 95% by mass or more, and cracking is not caused on the glass sheet even after elapsing 500 cycles in a prescribed thermal shock test.

Summary of Invention

Technical Problem

The connection terminal as mentioned above is fixed to the electricity supply portion via solder. However, if an external force acts on the connection terminal, the electricity supply portion or the glass plate may crack.

The present invention was made in order to solve the aforementioned problem, and it is an object thereof to provide a glass plate module in which a connection terminal or a wire is fixed to an electricity supply portion and that is capable of suppressing the generation of cracks in the glass plate or the electricity supply portion even if an external force acts on the connection terminal or wire.

Solution to Problem

1. A glass plate module to which a wire for supplying electric power is capable of being joined, including:

a glass plate;
a heating wire disposed on the glass plate; and
an electricity supply portion disposed on the glass plate, the wire being connected to the electricity supply portion, and the electricity supply portion supplying electric power to the heating wire,
wherein the heating wire is formed using a conductive print that contains, as a main component, the same metal microparticles as those contained in the electricity supply portion,
the electricity supply portion is formed using conductive print that contains, as a main component, metal microparticles whose thermal expansion coefficient is larger than that of the glass plate, and
the electricity supply portion is thinner than the heating wire.

Advantageous Effects of the Invention

With the present invention, generation of cracks in the electricity supply portion or glass plate can be suppressed.

Brief Description of Drawings

FIG. 1 is a plan view showing an embodiment of a windshield according to the present invention.

FIG. 2 is a cross-sectional view of FIG. 1.

FIG. 3 is a cross-sectional view of laminated glass.

FIG. 4 is a block diagram showing the schematic configuration of the in-vehicle system.

FIG. 5 is a plan view showing a heating body.

FIG. 6 is a cross-sectional view of a portion of the heating body in the vicinity of an electricity supply portion.

FIG. 7 is a cross-sectional view showing screen printing of the heating body.

FIG. 8 is a diagram showing an overview of a ring bending test.

FIG. 9 is a graph showing relationships between the thickness of the electricity supply portion on each type of glass plate and fracture stress.

FIG. 10 is a graph showing relationships between the reciprocal of the square of the thickness of the glass plate and fracture stress.

FIG. 11 is a graph showing a relationship between the thickness of the glass plate and the thickness of the electricity supply portion.

FIG. 12 is a cross-sectional view showing another example of the arrangement of the heating body.

FIG. 13 is a plan view of a windshield on which an antenna is disposed.

Description of Embodiments

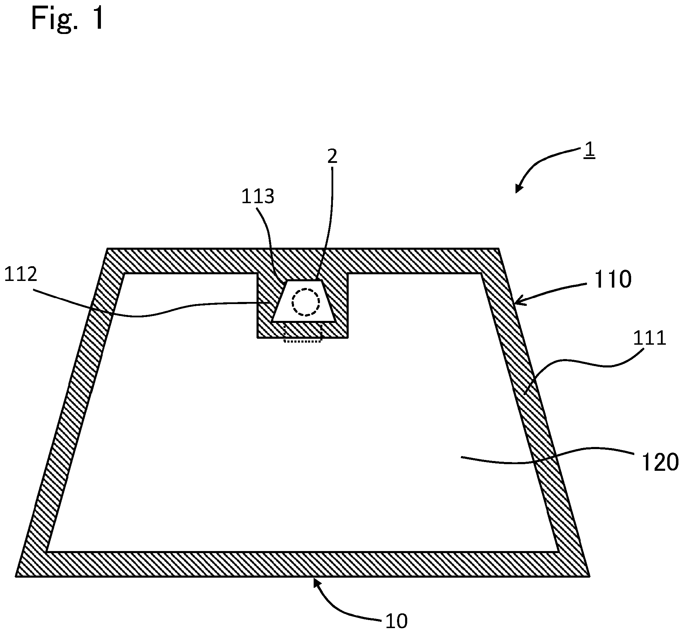

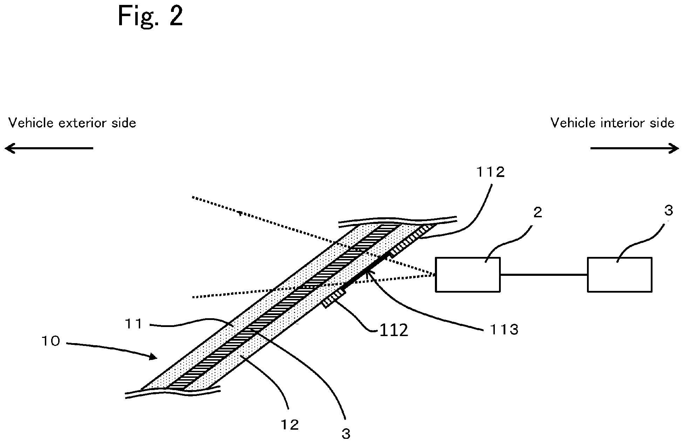

First, the configuration of a windshield according to this embodiment will be described with reference to FIGS. 1 and 2. FIG. 1 is a plan view of the windshield, and FIG. 2 is a cross-sectional view of FIG. 1. Note that, for the convenience of description, the "up-down direction" in FIG. 1 refers to "upper and lower", "perpendicular", and "vertical", and the "left-right direction" in FIG. 1 refers to "horizontal". FIG. 1 illustrates the windshield as viewed from the vehicle interior side. That is, the back side of the sheet of FIG. 1 corresponds to the vehicle exterior side, and the front side of the sheet of FIG. 1 corresponds to the vehicle interior side.

This windshield includes substantially rectangular laminated glass 10, and is installed in a vehicle body in an inclined state. An inner surface 130 of this laminated glass 10 that faces the vehicle interior side is provided with a mask layer 110 that blocks the field of view from the outside of the vehicle, and an imaging device 2 is disposed such that the mask layer 110 conceals the imaging device 2 from the outside of the vehicle. However, the imaging device 2 is a camera for taking images of the outside of the vehicle. Thus, the mask layer 110 is provided with an imaging window (opening) 113 at a position corresponding to the imaging device 2, and the imaging device 2 disposed inside the vehicle can take images of the outside of the vehicle through the imaging window 113.

An image processing device 3 is connected to the imaging device 2, and the image processing device 3 processes images taken by the imaging device 2. The imaging device 2 and the image processing device 3 are included in an in-vehicle system 5, and the in-vehicle system 5 can provide various pieces of information to a passenger in accordance with processing performed by the image processing device 3.

Also, as described later, a heating body 6 is disposed on the surface on the vehicle interior side of the windshield in a region corresponding to the imaging window 113, and the windshield is configured to prevent the region of the windshield that corresponds to the imaging window 113 from fogging up and to defrost this region. Hereinafter, these constituent elements will be described.

1. Laminated Glass

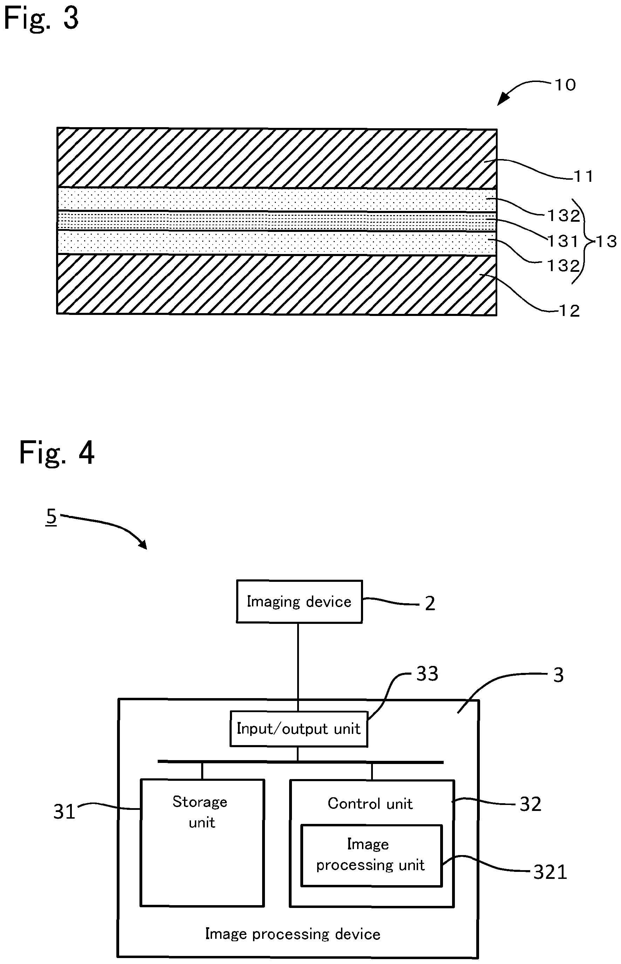

FIG. 3 is a cross-sectional view of laminated glass. As shown in FIG. 3, this laminated glass 10 includes an outer glass plate 11 and an inner glass plate 12, and a resin interlayer 3 is disposed between the glass plates 11 and 12. Hereinafter, the configurations thereof will be described.

1-1. Glass Plate

First, the outer glass plate 11 and the inner glass plate 12 will be described. Known glass plates can be used as the outer glass plate 11 and the inner glass plate 12, and these glass plates can also be made of heat-ray absorbing glass, regular clear glass or green glass, or UV green glass. However, the glass plates 11 and 12 are required to have a visible light transmittance that conforms to the safety standards of a country in which the automobile is to be used. For example, adjustments can be made so that solar absorptance that the outer glass plate 11 is required to have is ensured and the inner glass plate 12 provides a visible light transmittance that meets the safety standards. An example of clear glass, an example of heat-ray absorbing glass, and an example of soda-lime based glass are shown below.

Clear Glass

$SiO_2$: 70 to 73 mass%
$Al_2O_3$: 0.6 to 2.4 mass%
CaO: 7 to 12 mass%
MgO: 1.0 to 4.5 mass%
$R_2O$: 13 to 15 mass% (R represents an alkali metal)
Total iron oxide (T-$Fe_2O_3$) in terms of $Fe_2O_3$: 0.08 to 0.14 mass%

Heat-Ray Absorbing Glass

With regard to the composition of heat-ray absorbing glass, a composition obtained based on the composition of clear glass by setting the ratio of the total iron oxide (T-$Fe_2O_3$) in terms of $Fe_2O_3$ to 0.4 to 1.3 mass%, the ratio of $CeO_2$ to 0 to 2 mass%, and the ratio of $TiO_2$ to 0 to 0.5 mass%, and reducing the components (mainly $SiO_2$ and $Al_2O_3$) forming the framework of glass by an amount corresponding to increases in T-$Fe_2O_3$, $CeO_2$, and $TiO_2$ can be used, for example.

Soda-Lime Based Glass

$SiO_2$: 65 to 80 mass%
$Al_2O_3$: 0 to 5 mass%
CaO: 5 to 15 mass%
MgO: 2 mass% or more
NaO: 10 to 18 mass%
$K_2O$: 0 to 5 mass%
MgO + CaO: 5 to 15 mass%
$Na_2O$ + $K_2O$: 10 to 20 mass%
$SO_3$: 0.05 to 0.3 mass%
$B_2O_3$: 0 to 5 mass%
Total iron oxide (T-$Fe_2O_3$) in terms of $Fe_2O_3$: 0.02 to 0.03 mass%

Although there is no particular limitation on the thickness of the laminated glass according to this embodiment, it is possible to set the total thickness of the outer glass plate 11 and the inner glass plate 12 to, for example, 2.1 to 6 mm, and the total thickness of the outer glass plate 11 and the inner glass plate 12 is preferably set to 2.4 to 3.8 mm, more preferably 2.6 to 3.4 mm, and particularly preferably 2.7 to 3.2 mm, from the viewpoint of weight reduction. As described above, there is a need to reduce the total thickness of the outer glass plate 11 and the inner glass plate 12 in order to achieve weight reduction. Therefore, although there is no particular limitation on the thicknesses of the glass plates, the thicknesses of the outer glass plate 11 and the inner glass plate 12 can be determined as described below, for example.

The outer glass plate 11 is mainly required to have durability and impact resistance against external hazards. When this laminated glass is used as, for example, a windshield of an automobile, impact-resistance against flying objects such as small stones is required. On the other hand, a larger thickness is not preferable because the weight increases. From this viewpoint, the thickness of the outer glass plate 11 is preferably 1.8 to 2.3 mm, and more preferably 1.9 to 2.1 mm. The thickness to be used can be determined in accordance with the application of the glass plate.

Although the thickness of the inner glass plate 12 can be made equal to that of the outer glass plate 11, the thickness of the inner glass plate 12 can be made smaller than that of the outer glass plate 11 in order to, for example, reduce the weight of the laminated glass. Specifically, when the strength of the glass plate is taken into consideration, the thickness is preferably 0.6 to 2.0 mm, more preferably 0.8 to 1.6 mm, and particularly preferably 1.0 to 1.4 mm. Furthermore, the thickness is preferably 0.8 to 1.3 mm. With regard to the inner glass plate 12 as well, the thickness to be used can be determined in accordance with the application of the glass plate.

Here, an example of a method of measuring the thickness of a curved glass plate (laminated glass) 1 will be described. First, with respect to the measurement position, the measurement is performed at two positions: an upper position and a lower position on a center line S extending vertically through the center of a glass plate in the horizontal direction. Although there is no particular limitation on the measuring apparatus, a thickness gauge such as SM-112 manufactured by TECLOCK Corporation can be used, for example. During measurement, the glass plate is disposed such that the curved surface of the glass plate is placed on a flat surface, and an end portion of the glass plate is sandwiched by and measured with the above-mentioned thickness gauge. Note that a flat glass plate can also be measured in the same manner as a curved glass plate.

As described later, the laminated glass 1 is provided with electricity supply portions 64 and 65 for supplying electricity to the heating body 6. At least a 9-mm$^2$ region is needed to attach a connection terminal or wire to each of these electricity supply portions 64 and 65. Since a force is applied to the wire, it is preferable that the glass plate has sufficient fracture strength such that the glass does not break when this region is subjected to a force of 50 N. This is based on a German automobile specification test (Test Specification of the AK2.1 of German Car Manufacturer).

Specifically, when the thickness of the outer glass plate 11 or inner glass plate 12 included in the laminated glass that is provided with the electricity supply portions 64 and 65 is defined as Dx (mm), it is preferable that fracture strength H (MPa) of this glass plate satisfies the following formula.

$$H \geq 76.8/Dx^2 \qquad (1)$$

1-2. Interlayer

The interlayer 3 includes at least one layer. For example, as shown in FIG. 3, the interlayer 3 can be configured by three layers, namely a soft core layer 131 and outer layers 132 that are harder than the core layer 131 and between which the core layer 131 is held. However, there is no limitation to this configuration, and it is sufficient that the interlayer 3 includes a plurality of layers including the core layer 131 and at least one outer layer 132 disposed on the outer glass plate 11 side. For example, the interlayer 3 that includes two layers, namely the core layer 131 and one outer layer 132 disposed on the outer glass plate 11 side, or the interlayer 3 in which an even number of two or more of the outer layers 132 are disposed on each side of the core layer 131 so that the core layer 131 is disposed at the center, or the interlayer 3 in which an odd number of outer layers 132 are disposed on one side of the core layer 131 and an even number of outer layers 132 are disposed on the other side so that the core layer 131 is located therebetween can also be formed. Note that, in the case where only one outer layer 132 is provided, the outer layer 132 is provided on the outer glass plate 11 side as mentioned above, which is for the purpose of improving the breakage resistance against an external force from the outside of a vehicle or a building. Also, when the number of outer layers 132 is increased, the sound insulation performance is improved.

There is no particular limitation on the hardness of the core layer 131 as long as the core layer 131 is softer than the outer layer 132. Although there is no particular limitation on the materials constituting the layers 131 and 132, it is possible to select materials based on, for example, the Young's modulus. Specifically, at a frequency of 100 Hz and a temperature of 20°C, the Young's modulus is preferably 1 to 20 MPa, more preferably 1 to 18 MPa, and particularly preferably 1 to 14 MPa. When the Young's modulus is set to be in such a range, it is possible to prevent a decrease in STL in a low frequency range of about 3500 Hz or lower. On the other hand, as will be described later, it is preferable that the outer layers 132 have a large Young's modulus for the purpose of improving the sound insulation performance in a high frequency range, and the Young's modulus can be set to 560 MPa or more, 600 MPa or more, 650 MPa or more, 700 MPa or more, 750 MPa or more, 880 MPa or more, or 1300 MPa or more at a frequency of 100 Hz and a temperature of 20°C. Meanwhile, there is no particular limitation on the upper limit of the Young's modulus of each of the outer layers 132, but the Young's modulus can be set from the viewpoint of, for example, workability. For example, it is empirically known that when the Young's modulus is set to 1750 MPa or more, the workability decreases, and cutting becomes particularly difficult.

Also, the outer layers 132 can be made of, for example, a polyvinyl butyral resin (PVB) as a specific material. A polyvinyl butyral resin has excellent adhesiveness to the glass plates and penetration resistance and is thus preferable. On the other hand, the core layer 131 can be made of an ethylene vinyl acetate resin (EVA) or a polyvinyl acetal resin, which is softer than the polyvinyl butyral resin constituting the outer layers. Arranging the soft core layer between the outer layers makes it possible to significantly improve the sound insulation performance while keeping adhesiveness and penetration resistance that are equivalent to those of a single-layered resin interlayer.

In general, the hardness of a polyvinyl acetal resin can be controlled by adjusting (a) the degree of polymerization of polyvinyl alcohol, which is the starting material, (b) the degree of acetalization, (c) the type of plasticizer, (d) the ratio of the plasticizer to be added, and the like. Accordingly, a hard polyvinyl butyral resin that is used for the outer layers 132 and a soft polyvinyl butyral resin that is used for the core layer 131 can be produced with the same polyvinyl butyral resin by appropriately adjusting at least one condition selected from the aforementioned conditions. Furthermore, the hardness of a polyvinyl acetal resin can be controlled based on the type of aldehyde that is used for acetalization and whether co-acetalization using a plurality of kinds of aldehydes or pure acetalization using a single kind of aldehyde is performed. Although not necessarily applicable to every case, the larger the number of carbon atoms of the aldehyde that is used to obtain a polyvinyl acetal resin, the softer the resulting polyvinyl acetal resin tends to be. Accordingly, for example, if the outer layers 132 are made of a polyvinyl butyral resin, a polyvinyl acetal resin that is obtained by acetalizing an aldehyde having 5 or more carbon atoms (e.g. , n-hexyl aldehyde, 2-ethylbutyl aldehyde, n-heptyl aldehyde, or n-octyl aldehyde) with polyvinyl alcohol can be used for the core layer 131. Note that there is no limitation to the above-mentioned resins and the like as long as predetermined Young's moduli can be obtained.

The total thickness of the interlayer 3 is not particularly specified, and is preferably 0.3 to 6.0 mm, more preferably 0.5 to 4.0 mm, and particularly preferably 0.6 to 2.0 mm. Also, the thickness of the core layer 131 is preferably 0.1 to 2.0 mm and more preferably 0.1 to 0.6 mm. Meanwhile, the thickness of each of the outer layers 132 is preferably 0.1 to 2.0 mm and more preferably 0.1 to 1.0 mm. Alternatively, it is also possible to fix the total thickness of the interlayer 3 and adjust the thickness of the core layer 131 without exceeding the fixed total thickness.

The thicknesses of the core layer 131 and the outer layers 132 can be measured, for example, as described below. First, a cross section of laminated glass is displayed enlarged by a factor of 175 using a microscope (e.g., VH-5500 manufactured by Keyence Corporation). Then, the thicknesses of the core layer 131 and the outer layers 132 are visually identified and measured. At this time, in order to eliminate variations seen in visual identification, the measurement is performed five times, and average values are taken as the thicknesses of the core layer 131 and the outer layers 132. For example, an enlarged photograph of laminated glass is taken, in which the core layer and the outer layers 132 are identified and the thicknesses thereof are measured.

Note that the core layer 131 and the outer layers 132 of the interlayer 3 are not required to have a constant thickness along the entire surface of the laminated glass. For example, the core layer 131 and the outer layers 132 can also have a wedge shape so as to be suited to a laminated glass that is used for a head-up display. In this case, the thicknesses of the core layer 131 and the outer layers 132 of the interlayer 3 are measured at positions having the smallest thickness, that is, in the lowest side portion of the laminated glass. If the interlayer 3 has a wedge shape, the outer glass plate and the inner glass plate are not disposed in parallel, but it should be construed that such an arrangement is also included in the arrangement of the glass plates of the present invention. That is, the arrangement according to the present invention includes, for example, the arrangement of the outer glass plate and the inner glass plate when the interlayer 3 that includes the core layer 131 and the outer layers 132 whose thicknesses increase at a rate of change of 3 mm or less per meter is used.

Although there is no particular limitation on the method of manufacturing the interlayer 3, examples thereof include a method in which a resin component, such as the above-described polyvinyl acetal resin, a plasticizer, and other additives, if necessary, are mixed and uniformly kneaded, and then the layers are collectively extruded, and a method in which two or more resin films that are produced using this method are laminated using a pressing process, a lamination process, or the like. In the method of laminating using the pressing process, the lamination process, or the like, each of the resin films before laminating may have a single-layer structure or a multilayer structure. Also, the interlayer 3 may include a single layer instead of the plurality of layers as mentioned above.

2. Mask Layer

Next, the mask layer 110 will be described. As illustrated in FIGS. 1 and 2, in this embodiment, the mask layer 110 is layered on an inner surface (an inner surface of the inner glass plate 12) 130 on the vehicle interior side of the laminated glass 10, and is formed along a peripheral edge portion of the laminated glass 10. Specifically, as illustrated in FIG. 1, the mask layer 110 according to this embodiment includes a peripheral edge region 111 extending along the peripheral edge portion of the laminated glass 10, and a protruding region 112 that protrudes downward from the upper side of the laminated glass 10 in a rectangular shape. The peripheral edge region 111 blocks light entering from the peripheral edge portion of the windshield. On the other hand, the protruding region 112 conceals the imaging device 2 disposed inside the vehicle from the outside of the vehicle.

However, if the mask layer 110 blocks the imaging range of the imaging device 2, the imaging device 2 cannot take images of situation forward of the vehicle exterior. Thus, in this embodiment, the protruding region 112 of the mask layer 110 is provided with a trapezoidal imaging window 113 at a position corresponding to the imaging device 2 such that the imaging device 2 can take images of the outside of the vehicle. That is to say, the imaging window 113 is provided independently of a non-blocking region 120 on the inner side in the in-plane direction with respect to the mask layer 110. Also, this imaging window 113 is a region where the material of the mask layer 110 is not layered, and thus it is possible to take images of the outside of the vehicle due to the laminated glass having the above-described visible light transmittance. Note that the size of the imaging window 113 is not particularly limited, and may be set to, for example, 7000 $mm^2$ or more.

As described above, the mask layer 110 may also be layered on an inner surface of the outer glass plate 11 and an outer surface of the inner glass plate 12, for example, in addition to being layered on the inner surface of the inner glass plate 12. Also, the mask layer 110 can be layered on two portions of the inner surface of the outer glass plate 11 and the inner surface of the inner glass plate 12.

Next, the material of the mask layer 110 will be described. The material of the mask layer 110 may be selected as appropriate according to embodiments as long as it can block the field of view from the outside of the vehicle, and a ceramic material with a dark color such as black, brown, gray, or dark blue may be used, for example.

If a black ceramic material is selected as the material of the mask layer 110, for example, the black ceramic material is layered on the peripheral edge portion of the inner surface 130 of the inner glass plate 12 through screen printing or the like, and the layered ceramic materials are heated together with the inner glass plate 12. Thus, it is possible to form the mask layer 110 on the peripheral edge portion of the inner glass plate 12. Also, when a black ceramic material is printed, a region where the black ceramic material is not partially printed is provided. Accordingly, it is possible to form the imaging window 113. Note that various materials can be used as the ceramic material used for the mask layer 110. For example, it is possible to use a ceramic material with a composition shown in Table 1 below for the mask layer 110.

Table 1

| | | First and second colored ceramics pastes |
|---|---|---|
| Pigment *1 | mass% | 10 |
| Resin (cellulose resin) | mass% | 10 |
| Organic solvent (pine oil) | mass% | 10 |
| Glass binder *2 | mass% | 70 |
| viscosity | dPs | 150 |
| *1, Main components: copper oxide, chromium oxide, iron oxide, and manganese oxide <br> *2, Main components: bismuth borosilicate, zinc borosilicate | | |

3. In-Vehicle System

Next, an in-vehicle system 5 provided with the imaging device (the information acquisition device) 2 and the image processing device 3 will be described with reference to FIG. 4. FIG. 4 illustrates the configuration of the in-vehicle system 5. As illustrated in FIG. 4, the in-vehicle system 5 according to this embodiment includes the above-mentioned imaging device 2 and the above-mentioned image processing device 3 connected to the imaging device 2.

The image processing device 3 is a device for processing images taken by the imaging device 2. This image processing device 3 includes, for example, general hardware such as a storage unit 31, a control unit 32, and an input/output unit 33 that are connected via a busbar, as a hardware configuration. However, the hardware configuration of the image processing device 3 is not limited to such an example, and, with regard to a specific hardware configuration of the image processing device 3, it is possible to add, or omit and add constituent elements as appropriate according to an embodiment.

The storage unit 31 stores various data and programs used in processing executed by the control unit 32 (not shown) . The storage unit 31 may be realized by, for example, a hard disk, or a recording medium such as a USB memory. Also, various data and programs stored in the storage unit 31 may be acquired from a recording medium such as a CD (Compact Disc) or a DVD (Digital Versatile Disc). Furthermore, the storage unit 31 may be referred to as an "auxiliary storage".

As described above, the laminated glass 10 is disposed in an inclined orientation with respect to the vertical direction, and is curved. Also, the imaging device 2 takes images of the outside of a vehicle via such a laminated glass 10. Thus, the images taken by the imaging device 2 are deformed according to the orientation, shape, refractive index, optical defects, and the like of the laminated glass 10. Aberrations that are specific to the camera lens of the imaging device 2 also cause deformation. In view of this, the storage unit 31 may store correction data for correcting images that are deformed due to aberrations of the laminated glass 10 and the camera lens.

The control unit 32 includes one or more processors such as a microprocessor or a CPU (Central Processing Unit), and peripheral circuits (a ROM (Read Only Memory), a RAM (Random Access Memory), an interface circuit, and the like) used for processing performed by these processors. The ROM, the RAM, and the like may be called the main storages in the sense that they are located in the address space handled by the processors in the control unit 32. The control unit 32 functions as an image processing unit 321 by executing various data and programs stored in the storage unit 31.

The image processing unit 321 processes images taken by the imaging device 2. Processing performed on the captured images can be selected as appropriate according to an embodiment. For example, the image processing unit 321 may recognize a subject present in a captured image by analyzing the captured image through pattern matching or the like. In this embodiment, since the imaging device 2 takes images of situation forward of the vehicle, the image processing unit 321 may further determine whether or not an organism such as a human being is present on the front side of the vehicle based on this subject recognition. Then, if a person is present on the front side of the vehicle, the image processing unit 321 may output a warning message, using a predetermined method. Also, the image processing unit 321 may perform a predetermined process on a captured image, for example. Then, the image processing unit 321 may output the processed captured image to a display device (not shown) such as a display connected to the image processing device 3.

The input/output unit 33 is one or more interfaces for transmitting and receiving data to/from a device that is present outside the image processing device 3. The input/output unit 33 is, for example, an interface for connecting to a user interface, or an interface of a USB (Universal Serial Bus). Note that, in this embodiment, the image processing device 3 is connected to the imaging device 2 via the input/output unit 33, and acquires images taken by the imaging device 2.

In addition to a device designed exclusively for a service to be provided, a general-purpose device such as a PC (Personal Computer) or a tablet terminal may be used as such an image processing device 3.

Also, the above-mentioned imaging device 2 is attached to a bracket (not shown), and the bracket is attached to the mask layer 110. Therefore, attachment of the imaging device 2 to the bracket and attachment of the bracket to the mask layer 110 are adjusted such that the optical axis of the camera of the imaging device 2 passes through the imaging window 113 in this state. Also, a cover (not shown) is attached to the bracket so as to cover the imaging device 2. Therefore, the imaging device 2 is disposed in the space surrounded by the laminated glass 10, the bracket, and the cover, and the imaging device 2 cannot be seen from the vehicle interior side, and only a portion of the imaging device 2 can be seen from the vehicle exterior side through the imaging window 113. Also, the imaging device 2 and the above-described input/output unit 33 are connected to each other by a cable (not shown), and this cable is drawn out from the cover and is connected to the image processing device 3 disposed at a predetermined position in the vehicle.

4. Overview of Heating Body

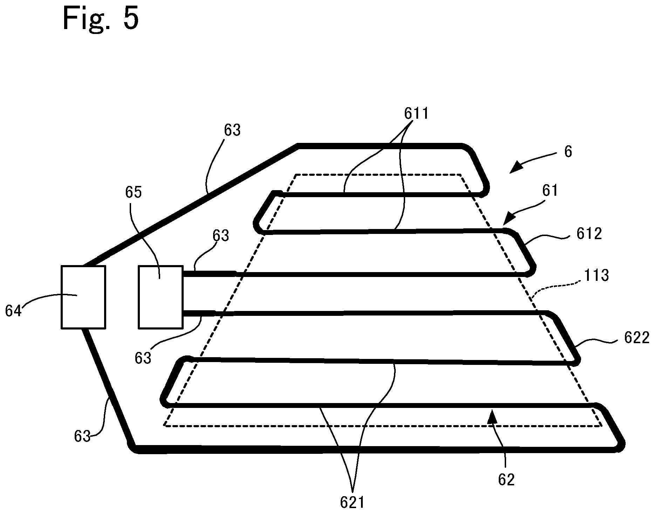

Next, the heating body 6 will be described with reference to FIG. 5. As shown in FIG. 5, the heating body 6 is constituted by a first heating wire 61, a second heating wire 62, connection wires 63, and two electricity supply portions 64 and 65, and the first heating wire 61 and the second heating wire 62 are disposed on the surface on the vehicle interior side of the inner glass plate 12 so as to pass the imaging window 113. More specifically, the first heating wire 61 and the second heating wire 62 are connected in parallel, and are disposed so as to pass the imaging window 113. The first heating wire 61 is disposed so as to pass the upper portion of the imaging window 113, and the second heating wire 62 is disposed so as to pass the lower portion of the imaging window 113.

The first heating wire 61 is constituted by a combination of a plurality of main portions 611 that pass the imaging window 113 and are disposed in parallel, and a plurality of coupling portions 612 that are disposed outside the imaging window 113 and each couple the end portions of the adjacent main portions 611. That is, the first heating wire 61 is a combination of the plurality of main portions 611 and the plurality of coupling portions 612, and is thus disposed so as to pass the imaging window 113 a plurality of times. The interval between the adjacent main portions 611 is not particularly limited, and is preferably, for example, 1 mm or more, and more preferably 5 mm or more. In particular, the interval between the main portions 611 of the first heating wire 61 is preferably 20 times as large as the wire width. This configuration is for the purpose of balancing the wire width of the first heating wire 61 and the interval. For example, if the wire width is reduced, the resistance increases, and thus a sufficient amount of heat is not obtained at a certain electrical voltage. In addition, if the interval of the first heating wire 61 is reduced, the view from the imaging device 2 is blocked, which may affect the field of view.

The coupling portions 612 are each formed in a U-shape, but can also be formed in an overall curved shape. The reason for this is that, if the coupling portion 612 includes a sharp corner portion (bent portion), there is a risk that heat will be abnormally generated.

Both of the end portions of the first heating wire 61 are respectively coupled to a first electricity supply portion 64 and a second electricity supply portion 65 via the above-mentioned connection wires 63. The electricity supply portions 64 and 65 are formed in a rectangular shape, and the terminals are fixed to the electricity supply portions 64 and 65 via solder, as will be described later. A source voltage of, for example, 10 to 50 V is applied to the terminals.

Although the first electricity supply portion 64 and the second electricity supply portion 65 are disposed at positions away from the imaging window 113, both of them are disposed on the mask layer 110. Also, the connection wires 63 are disposed on the mask layer 110.

The second heating wire 62 has a configuration similar to that of the first heating wire 61. That is, the second heating wire 62 is constituted by a combination of a plurality of main portions 621 that pass the imaging window 113 and are disposed in parallel, and a plurality of bent portions 622 that are disposed outside the imaging window 113 and each couple the end portions of the adjacent main portions 621. Also, the second heating wire 62 is a combination of the plurality of main portions 621 and the plurality of bent portions 622, and is thus disposed so as to pass the imaging window 113 a plurality of times. Note that the main portions 621 of the second heating wire 62 are disposed in parallel with the main portions 611 of the first heating wire 61. Both of the end portions of the second heating wire 62 are respectively coupled to the first electricity supply portion 64 and the second electricity supply portion 65 via the above-mentioned connection wires 63. Accordingly, the first heating wire 61 and the second heating wire 62 are connected to the two electricity supply portions 64 and 65 in the state of being parallel with each other, and each form a parallel circuit. For example, if the imaging window 113 has a large area, the lengths of the main portions 611 and 612 increase, and thus the amount of heat generated by the main portions may decrease. Therefore, when the heating body 6 includes a plurality of parallel circuits, the lengths of the first heating wire 61 and the second heating wire 62 decrease, thus making it possible to generate a sufficient amount of heat. Note that, if a constant electrical voltage is applied, a sufficient electrical current is allowed to flow by reducing the resistance. As a result, a sufficient amount of heat can be generated.

When the lengths of the connection wires 63 are increased, the resistance of these portions increases, and thus an amount of generated heat can be adjusted. That is, adjustment can be performed such that an amount of heat generated by the first and second heating wires 61 and 62 decreases.

The wire widths of the heating wires 61 and 62 are preferably, for example, 1 to 500 $\mu$m, and more preferably 1 to 400 $\mu$m. Furthermore, the wire widths are preferably 1 to 300 $\mu$m. The reason for this is that the smaller the wire width is, the harder it is to see the wires, and the more suitable for the imaging window 113 they are. In particular, it is preferable to set the wire widths of the main portions 611 and 621 of the heating wires 61 and 62 to be within the range above. On the other hand, wires with an excessively small thickness may be incapable of being manufactured. Moreover, if a constant electrical voltage is applied to a parallel circuit with an excessively small wire width, the resistance increases. As a result, an electrical current flowing in the circuit decreases, and thus sufficient heating cannot be performed. Note that the wire width as used herein means the wire width of the largest portion in the cross section of each heating wires 61 and 62. For example, when the heating wires 61 and 62 have a trapezoidal cross section, the width of the lower side is taken as the wire width, and when the heating wires 61 and 62 have a circular cross section, the diameter is taken as the wire width. For example, the widths of the heating wires 61 and 62 can be measured in a state of being enlarged by a factor of 1000 using a microscope such as VHX-200 (manufactured by Keyence Corporation).

Also, the thicknesses of the heating wires 61 and 62 and the connection wires 63 are preferably 4 to 20 $\mu$m, and more preferably 5 to 15 $\mu$m. The reason for this is as follows: if the thickness is less than 4 $\mu$m, when the heating wires 61 and 62 and the connection wires 63 are printed on the mask layer 110, for example, the mask layer 110 may absorb metal microparticles contained in the heating wires etc. 61 to 63, as will be described later, and thus there is a possibility that the thicknesses of the heating wires etc. 61 to 63 change and uniform resistance cannot be obtained. On the other hand, if the thickness is more than 20 $\mu$m, the resistance becomes too small, and thus there is a possibility that local breakage occurs in the glass plate.

The heating wires 61 and 62, the connection wires 63, and the electricity supply portions 64 and 65 included in the heating body 6 are made of silver. The heating wires 61 and 62, the connection wires 63, and the electricity supply portions 64 and 65 are formed, for example, through printing such as screen printing. That is, the heating wires 61 and 62, the connection wires 63, and the electricity supply portions 64 and 65 are formed by applying a silver paste containing silver as metal microparticles through printing and then drying the paste. Note that, although the entire portion of the heating body 6 may be integrally formed through printing or the like, different materials can also be used to form the heating body 6. For example, a configuration is also possible in which only the electricity supply portions 64 and 65 are formed using silver, whereas the heating wires 61 and 62 and the connection wires 63 are formed using a material different from silver. For example, the heating wires 61 and 62 and the connection wires 63 can be formed using a material containing various metal microparticles made of copper (or tin-plated copper), gold, aluminum, magnesium, cobalt, tungsten, and the like. In particular, it is preferable to use copper, gold, and aluminum, which are materials having an electric resistivity of $3.0 \times 10^{-8}$ Qm or less, out of these metals.

When the electricity supply portions 64 and 65 contains silver metal microparticles, the electricity supply portions 64 and 65 formed using a silver paste preferably have a conductivity of 2 $\mu\Omega\cdot$cm or more and 10 $\Omega\cdot$cm or less, and more preferably 2 $\mu\Omega\cdot$cm or more and 4 Q-cm or less. Differences in heat shrinkage ratios in silver print largely depend on the silver content. Also, the resistivity depends on the silver content. Accordingly, the above-mentioned conductivity is preferable.

5. Arrangement of Terminal in Electricity Supply Portion

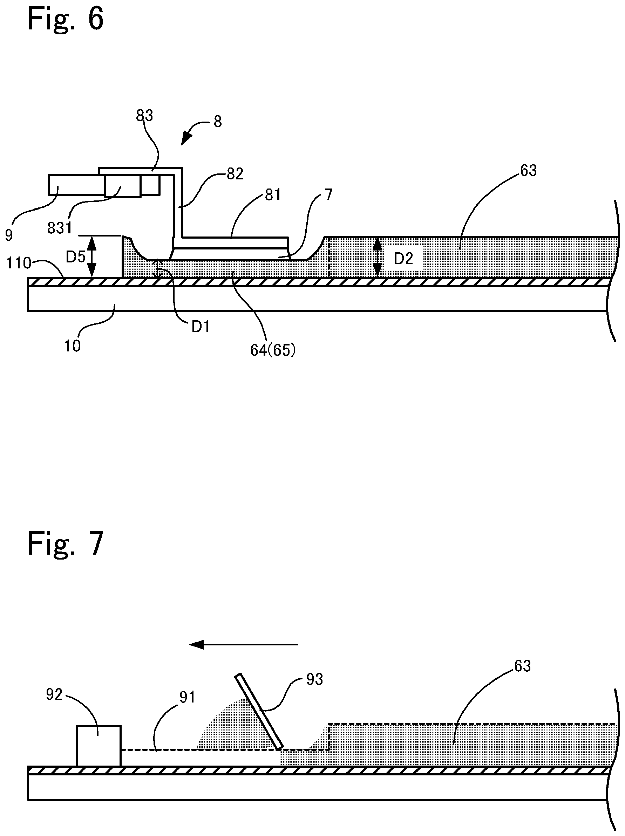

Next, the arrangement of terminals in the electricity supply portions 64 and 65 will be described. As shown in FIG. 6, a terminal 8 is fixed to each of the electricity supply portions 64 and 65 via solder 7. The terminal 8 includes a plate-like installation portion 81, an upright portion 82 that stands upright from the end portion of the installation portion 81, and an extension portion 83 that extends from the upper end of the upright portion 82 substantially in parallel with the installation portion 81, and is formed in one piece using a plate-like conductive material. Plate-like fixation portions 831 are provided on both sides of the extension portion 83, and a conductive cable 9 is crimped by these fixation portions 831. Accordingly, electric power supplied through the conductive cables is supplied to the electricity supply portions 64 and 65 via the terminals 8 and the solder 7, and thus the heating wires 61 and 62 generate heat.

The solder 7 may be lead-free solder or lead-containing solder, and lead-free solder is preferable. In the case of using lead-free solder, lead-free solder that contains Sn, for example, in an amount of 90% or more is hard, and therefore, a laminated glass plate may crack if such lead-free solder is joined thereto. Even in such a case, it is sufficient that soft lead-free solder such as indium-based or bismuth-based lead-free solder is used and joined thereto. Note that, when lead-free solder is used, a force applied to a glass plate increases because the ductility of lead-free solder is lower than that of lead-containing solder. Accordingly, in the case of using lead-free solder, the glass plate is more likely to crack compared with the case of using lead-containing solder. Therefore, this embodiment exhibits a particularly large crack preventing effect when lead-free solder is used, as described later.

Although the electricity supply portions 64 and 65 are formed in a rectangular shape in this embodiment, there is no particular limitation on the shape thereof as long as they are larger than the installation portions 81 of the terminals 8. Also, the electricity supply portions 64 and 65 are thinner than the heating wires 61 and 62 and the connection wires 63. More specifically, the thicknesses of the electricity supply portions 64 and 65 are preferably, for example, 3 to 15 $\mu$m, and more preferably 3 to 10 $\mu$m. On the other hand, the heating wires 61 and 62 and the connection wires 63 are thicker than the electricity supply portions 64 and 65, and the thicknesses thereof are preferably, for example, 4 to 20 $\mu$m, and more preferably 5 to 15 $\mu$m. Note that, the relationship between the electricity supply portions 64 and 65 and the heating wires 61 and 62, which will be described below, can be applied to the relationship between the electricity supply portions 64 and 65 and the connection wires 63.

If the thicknesses of the electricity supply portions 64 and 65 are less than 3 $\mu$m, there is a risk that the solder 7 absorbs silver microparticles, and thus joining to a connector or harness cannot be achieved. On the other hand, if the thicknesses of the electricity supply portions 64 and 65 are 15 $\mu$m or more, there is a risk that the fracture strength of glass will decrease due to tension stress caused by the heating wires 61 and 62 or the connection wires 63, and thus fracture strength required for the glass cannot be obtained.

When the thicknesses of the electricity supply portions 64 and 65 are defined as D1, and the thicknesses of the connection wires 63 (or the heating wires 61 and 62) are defined as D2, D1 is smaller than D2, and it is preferable that D1/D2 is 0.4 or more and 0.9 or less.

Furthermore, it is preferable that the relationship between the thicknesses D1 of the electricity supply portions 64 and 65 and a thickness Dx of the inner glass plate 12 or outer glass plate 11 on which the electricity supply portions 64 and 65 are provided satisfies Formula (2) below.

$$D1 \leq (81.4 - (76.8/Dx^2))/3.0 \qquad (2)$$

When the electricity supply portions 64 and 65 are formed through screen printing, a supporting portion 92 that supports the peripheral edge of a screen 91 is taller than the screen 91, for example, as shown in FIG. 7. Moreover, the screens 91 differ in height in accordance with the thicknesses of the electricity supply portions 64 and 65 and the heating wires 61 to 63, which are different from each other. Accordingly, a squeegee 93 cannot sufficiently press the peripheral edge of the screen 91, and therefore, the edge portions of the electricity supply portions 64 and 65 tend to be higher than the central portions thereof. Here, the central portion is a portion on which the installation portion 81 of the terminal 8 and the solder 7 are to be disposed, and the thickness of this portion corresponds to the above-described thicknesses of the electricity supply portions 64 and 65, and is defined as D1 as described above. In addition, the thicknesses of the edge portions of the electricity supply portions 64 and 65 are referred to as D5. As mentioned above, the thicknesses D5 of the edge portions of the electricity supply portions 64 and 65 are larger than the thicknesses D1 of the central portions, and it is preferable that the relationship between the thicknesses D1 and D5 satisfy Formula (3) below.

$$0.4 \leq D1/D5 \leq 0.9 \qquad (3)$$

Setting D1/D5 to 0.4 or more makes it possible to ensure the resistance of the terminal 8 and to suppress generation of heat by the terminal 8. On the other hand, setting D1/D5 to 0.9 or less makes it possible to suppress tension stress caused by the difference in thermal expansion between silver and a glass plate.

The heating body 6 configured as mentioned above is covered by the bracket and the cover and cannot be thus seen from the inside of the vehicle. Also, the connection wires 63 and the electricity supply portions 64 and 65 are disposed on the mask layer 110 and cannot be thus seen from the outside of the vehicle as well. Note that the heating wire 6 need not be entirely covered by the bracket and the cover, and at least a portion thereof corresponding to the imaging window 113 may be covered by the bracket and the cover. Alternatively, only portions of the electricity supply portions 64 and 65 and the connection wires 63 may protrude from the bracket. However, in order to prevent the heating wire 6 from being touched from the inside of the vehicle, it is preferable that the entire heating wire 6 is entirely covered by the bracket and the cover. Note that, for example, even if a portion of the heating wire 6 protrudes from the bracket, it is sufficient that the portion is covered by the cover.

6. Method for Manufacturing Windshield

Next, a method for manufacturing a windshield will be described. First, the mask layer 110 is layered on at least one of the outer glass plate 11 and the inner glass plate 12 formed in predetermined shapes. Next, the above-described heating body 6 is formed through printing on a surface (including the mask layer 110) on the vehicle interior side of the inner glass plate 12. Then, these glass plates 11 and 12 are shaped to be curved. Although there is no particular limitation on the method therefor, known press-molding can be used, for example. Alternatively, once the outer glass plate 11 and the inner glass plate 12 have been placed on each other on a mold, the mold is heated by passing the mold through a heating furnace. Accordingly, the glass plates 11 and 12 can be curved under their own weight.

After the outer glass plate 11 and the inner glass plate 12 are molded in this manner, a laminate is formed in which the interlayer 3 is sandwiched between the outer glass plate 11 and the inner glass plate 12. Note that the interlayer 3 is larger than the glass plates 11 and 12.

Next, the laminate is placed into a rubber bag, and preliminarily bonding is carried out at about 70°C to 110°C under vacuum suction. Preliminary bonding can be carried out using a method other than this method, and the following method can also be adopted. For example, the above-mentioned laminate is heated in an oven at 45 to 65°C. Subsequently, this laminate is pressed by a roll at 0.45 to 0.55 MPa. Then, the laminate is heated in an oven again at 80 to 105°C, and is then pressed again by a roll at 0.45 to 0.55 MPa. Preliminary bonding is completed in this manner.

Then, permanent bonding is performed. The preliminarily bonded laminate is permanently bonded using an autoclave, for example, at a pressure of 8 to 15 atm and at 100 to 150°C. Specifically, permanent bonding can be performed, for example, under the conditions of 14 atm of pressure and a temperature of 135°C. The interlayer 3 is bonded to the glass plates 11 and 12 through preliminary bonding and permanent bonding described above. Then, a portion of the interlayer 3 that protrudes from the outer glass plate 11 and the inner glass plate 12 is cut off.

Thereafter, the terminals 8 are fixed to the electricity supply portions 64 and 65 using the solder 7. A windshield is completed in this manner.

7. Features

With the above-described windshield, it is possible to obtain the following effects.

(1) As a result of the heating wires 61 and 62 being provided so as to pass the imaging window 113, it is possible to prevent the laminated glass 10 in the imaging window 113 from fogging up. Furthermore, the laminated glass 10 can be defrosted by the heating wires 61 and 62. Thus, when light is received by the imaging device 2 through the imaging window 113, it is possible to prevent flaws such as hindering the passage of light due to the imaging window 113 being fogged up and thereby being unable to make accurate measurements. As a result, information processing can be accurately performed.

(2) Since the heating body 6 is covered by the bracket and the cover, the heating cover 6 cannot be seen from the vehicle interior side. Also, it is possible to prevent a passenger from touching the heating body 6.

(3) Although no tensile force may be applied to the heating wires 61 and 62 from the outside, an external force may act on connection terminals or wires for supplying electricity that are joined to the electricity supply portions 64 and 65, and thus the electricity supply portions or the glass plate may crack. Therefore, the electricity supply portions 64 and 65 need to have a higher glass fracture strength compared with the heating wires 61 and 62. Accordingly, in this embodiment, the thicknesses D1 of the electricity supply portions 64 and 65 are smaller than the thicknesses D2 of the heating wires 64 and 65. The electricity supply portions 64 and 65 contain metal microparticles made of silver or the like, and the heat shrinkage ratio thereof is significantly different from that of the glass plate 10. Therefore, if the thicknesses of the electricity supply portions are large, a problem arises in that tension stress generated in the glass plate 10 decreases, and thus the fracture strength of the glass plate 10 decreases.

Therefore, in this embodiment, tension stress generated in the glass plate 10 is reduced by setting the thicknesses of the electricity supply portions 64 and 65 to be smaller than those of the heating wires 61 and 62, and thus the fracture strength of the glass plate 10 corresponding to the electricity supply portions 64 and 65 is improved. As a result, even if an external force acts on the electricity supply portions 64 and 65, it is possible to suppress generation of cracks in the glass plate 10 or the electricity supply portions 64 and 65.

In particular, regarding the relationship between the thicknesses D1 of the electricity supply portions 64 and 65 and the thicknesses D2 of the thinnest portions of the heating wires 61 and 62 (or connection wires 63), D1/D2 is preferably 0.4 or more and 0.9 or less. The reason for this is as follows. Since the electricity supply portions 64 and 65 are wider than the heating wires 61 and 62, the electric current density per unit width decreases, thus suppressing generation of heat. However, the electric current density increases at portions that are joined to the heating wires 61 and 62. Therefore, if the value of D1/D2 is smaller than 0.4, the difference in thickness at portions where the electricity supply portions 64 and 65 are joined to the heating wires 61 and 62 increases and thus heat is generated, which leads to energy loss. On the other hand, if D1/D2 is larger than 0.9, the thicknesses of the electricity supply portions 64 and 65 are excessively large. Therefore, the fracture strength at the electricity supply portions 64 and 65 decreases as mentioned above, and thus the glass plate 10 may crack.

(4) Since the electricity supply portions 64 and 65 are wider than the heating wires 61 and 62 and the connection wires 63, an amount of heat generated by the electricity supply portions 64 and 65, which have no need to generate heat, can be reduced, and heat generated by the heating wires 61 and 62 can be increased, thus making it possible to heat the imaging window 113.

Also, the electricity supply portions 64 and 65 are formed using conductive print that contains metal microparticles made of silver or the like. The heating body 6 that includes the electricity supply portions 64 and 65 is printed prior to molding of the glass plate, and adheres to the inner glass plate 12 during glass molding. However, when they are cooled to the ordinary temperature, thermal stress is generated at the interface between the heating body 6 and the inner glass plate 12 due to a difference in thermal expansion between the heating body 6 and the glass plate. As a result, the fracture strength of the inner glass plate 12 decreases at positions where the electricity supply portions 64 and 65 are formed.

As mentioned above, in this embodiment, the electricity supply portions 64 and 65 are thinner than the heating wires 61 and 62. When the thicknesses d (D1 as described above) of the electricity supply portions 64 and 65 is reduced as shown in Formula (4) below, warping of the glass plate ($1/R_{DTE}$) can be reduced, thus making it possible to reduce tension stress generated at the surface of the glass plate. As a result, it is possible to suppress a decrease in the fracture strength of the glass plate 12 at positions where the electricity supply portions 64 and 65 are formed.

[Mathematical Formula 1]

$$\left(\frac{1}{R}\right)_{DTE} = \frac{6E_f\left(1-v_S\right)d}{E_S\left(1-v_f\right)D^2}\left(\alpha_f - \alpha_S\right)\Delta T \qquad (4)$$

$E_f$: Young's modulus of silver, $E_s$: Young's modulus of glass plate, $v_f$: Poisson's ratio of silver, $v_s$: Poisson's ratio of glass plate, d: Thickness of electricity supply portion, D: Thickness of glass plate, $\alpha_f$: Thermal expansion coefficient of silver, $\alpha_s$: Thermal expansion coefficient of glass plate, $\Delta T$: Temperature difference between temperature at which electricity supply portion adheres and room temperature, $1/R_{DTE}$: Curvature of interface between electricity supply portion and glass plate

(5) It is necessary to decrease the wire widths of the heating wires 61 and 62 disposed on the imaging window 113 as mentioned above in order not to block the camera view, and to reduce the resistance thereof in order to secure a certain amount of generated heat. Therefore, it is necessary to increase the thicknesses of the heating wires 61 and 62.

As described later, in the case of using the heating wires as deicers, it is also necessary to decrease the wire widths in order to secure an amount of heat generated per unit area, and to reduce the value of resistance in order to achieve sufficient heating using a certain electric current. Therefore, as in the case above, it is necessary to increase the thicknesses of the heating wires.

Furthermore, as described later, the antenna conductor preferably has a small wire width because a wide antenna conductor is likely to be visually confirmed by a passenger. However, it is necessary to increase the thickness of the antenna conductor in order to adjust the impedance of the antenna conductor.

However, when the heating wires 61 and 62, the connection wires 63, and the electricity supply portions 64 and 65 (referred to as "heating wires etc." hereinafter) are formed through screen printing, the thicknesses thereof cannot be changed because the thicknesses of the heating wires etc. to be printed are determined in accordance with the heights or thicknesses of screen meshes.

To address this, the inventor of the present invention found that, when narrow heating wires etc. are formed through screen printing, the thicknesses of the heating wires etc. can be controlled by controlling the thickness of an emulsion applied to the screen. That is, the thickness of the screen is controlled by applying an emulsion to the upper surface of the screen, and thus the thicknesses of the heating wires etc. are controlled. Accordingly, when the thickness of the emulsion is increased, it is possible to increase the thickness of a formed print product, and when the thickness of the emulsion is reduced or no emulsion is applied, it is possible to reduce the thickness of a formed print product. As a result, it is possible to set the thicknesses of the electricity supply portions 64 and 65 to be different from those of the heating wires etc.

Note that a method in which an inkjet printer is used may be employed instead of screen printing. In this method, the thickness of a print product is determined in accordance with the ink wetability of glass, and therefore, it is difficult to control the thickness of a print product. To address this, the concentration of conductive metal microparticles is adjusted by diluting the ink with a solvent, and thus it is possible to adjust the thickness of a fired product. As a result, it is possible to reduce the thicknesses of the heating wires etc. On the other hand, if the thicknesses of the heating wires etc. are increased, it is sufficient that printing is repeated, or less-diluted ink is used.

Here, the following tests were carried out in order to examine the thicknesses and the like of the electricity supply portions 64 and 65.

A. Test 1

As shown below, a glass plate made of soda-lime based glass with a thickness of 1.8 mm or a product obtained by layering a mask layer (having a composition as listed in Table 1 above) with a thickness of 10 $\mu$m on this glass plate was prepared, and a tensile test was carried out. The tensile test was as follows . An electricity supply portion with a length of 10 mm and a width of 5 mm was formed on the glass plate using a paste containing silver (conductive metal microparticles) or a paste containing copper (conductive metal microparticles), and lead-free solder was applied to a 9-mm$^2$ area on the electricity supply portion. A wire was fixed to this lead-free solder, and this wire was pulled with a force of 50 N at a right angle with the glass plate. Then, the results were evaluated based on the following criteria.

A: The electricity supply portion did not peel away from the glass plate.
B: Although a portion of the electricity supply portion remained, the electricity supply portion peeled away at the interface with the glass plate.
C: The electricity supply portion peeled away at the interface with the glass plate or from the mask layer.
D: The electricity supply portion peeled away due to breakage of glass at a portion of the glass plate under the electricity supply portion.

The results were as follows.

Table 2

| Conductive microparticles | Thickness of electricity supply portion | Substrate | Tensile test |
|---|---|---|---|
| Ag | 4.0 $\mu$m | Glass plate | A |
| Ag | 3.2 $\mu$m | Glass plate | A |
| Ag | 3.1 $\mu$m | Glass plate with mask layer | A |
| Ag | 3.0 $\mu$m | Glass plate | A |
| Ag | 2.8 $\mu$m | Glass plate | B |
| Ag | 2.9 $\mu$m | Glass plate with mask layer | B |
| Ag | 2.5 $\mu$m | Glass plate | C |
| Ag | 2.0 $\mu$m | Glass plate | C |
| Cu | 3.1 $\mu$m | Glass plate | A |
| Cu | 2.8 $\mu$m | Glass plate | B |
| Cu | 2.0 $\mu$m | Glass plate | C |

It was found from the results above that the thickness of the electricity supply portion was preferably 3.0 $\mu$m or more. Note that, when silver and copper are compared, the linear thermal expansion coefficient of silver is 18.9 $\mu$m/(m·K), while the thermal expansion coefficient of copper is 16.5 $\mu$m/(m·K). Accordingly, since the thermal expansion coefficient of silver is higher, a difference in thermal expansion coefficient between silver and the glass plate is greater. Therefore, when the electricity supply portion is formed using silver, cracks are more likely to be generated. Accordingly, the electricity supply portion was formed using silver in Test 2, which will be described next. In particular, a silver paste containing metal in an amount of 95% after firing was used. Note that a difference in thermal expansion coefficient between the mask layer and the glass plate is smaller than that between silver and the glass plate, and therefore, an influence of the mask layer is considered as being negligible.

B. Test 2

Three types of glass plates having different thicknesses were used, and electricity supply portions made of silver with different thicknesses were formed. A wire was connected to the electricity supply portion via lead-free solder in the same manner as in Test 1. However, in Test 2, a mask layer was not formed, and the electricity supply portion was formed directly on the glass plate. The thus-prepared samples were subjected to the above-described tensile test and a ring bending test (ASTM-C1499-1).

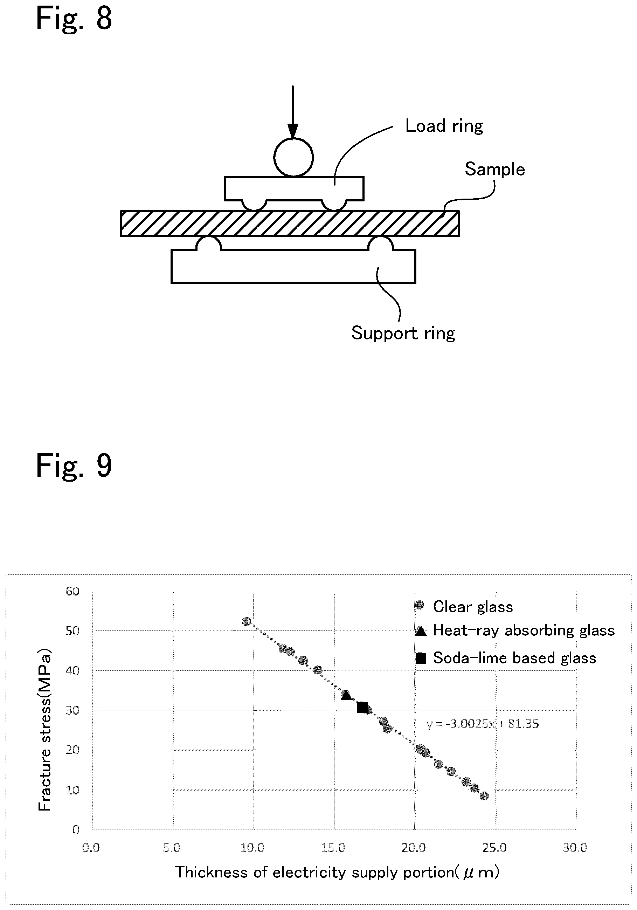

In the ring bending test, as shown in FIG. 8, a load ring with a diameter of 12 mm was disposed on the electricity supply portion, and a support ring with a diameter of 60 mm was disposed on the lower surface of the glass plate. Then, the electricity supply portion was pressed using the load ring at a stress rate of 1 MPa/sec, and the fracture stress (fracture strength) of the glass plate was calculated. The results were as follows.

Table 3

| Thickness of glass plate (mm) | Type of glass | Average thickness of electricity supply portion ($\mu$m) | Average fracture stress (MPa) | Tensile test |
|---|---|---|---|---|
| 2.3 | Clear glass | 20.4 | 20 | A |
| 2.3 | Clear glass | 22.3 | 14.5 | A |
| 2.3 | Clear glass | 23.2 | 12 | D |
| 2.3 | Clear glass | 24.3 | 8.5 | D |
| 2.0 | Clear glass | 18.3 | 25.3 | A |
| 2.0 | Clear glass | 20.7 | 19.2 | A |
| 2.0 | Clear glass | 21.5 | 16.4 | D |
| 2.0 | Clear glass | 23.7 | 10.5 | D |
| 1.6 | Clear glass | 12.3 | 44.7 | A |
| 1.6 | Clear glass | 17.1 | 30 | A |
| 1.6 | Heat-ray absorbing glass | 15.7 | 34 | A |
| 1.6 | Soda-lime based glass | 16.7 | 31 | A |
| 1.6 | Clear glass | 18.1 | 27.1 | D |
| 1.6 | Clear glass | 20.4 | 20.3 | D |
| 1.3 | Clear glass | 9.6 | 52.3 | A |
| 1.3 | Clear glass | 11.9 | 45.4 | A |
| 1.3 | Clear glass | 13.1 | 42.5 | D |
| 1.3 | Clear glass | 14 | 40.1 | D |

FIG. 9 is a graph showing relationships between the thickness of the electricity supply portion and fracture strength extracted from Table 3. It was found from the graph shown in FIG. 9 that relationships between the thickness of the electricity supply portion and fracture strength were substantially the same irrespective of the type of glass. Accordingly, it was found that fracture strength did not vary depending on the type of glass. Moreover, the relationship between the thickness of the electricity supply portion (x below) and fracture strength (y below) is expressed by Formula (5) below based on the graph shown in FIG. 9.

$$y = -3.0025x + 81.35 \quad (5)$$

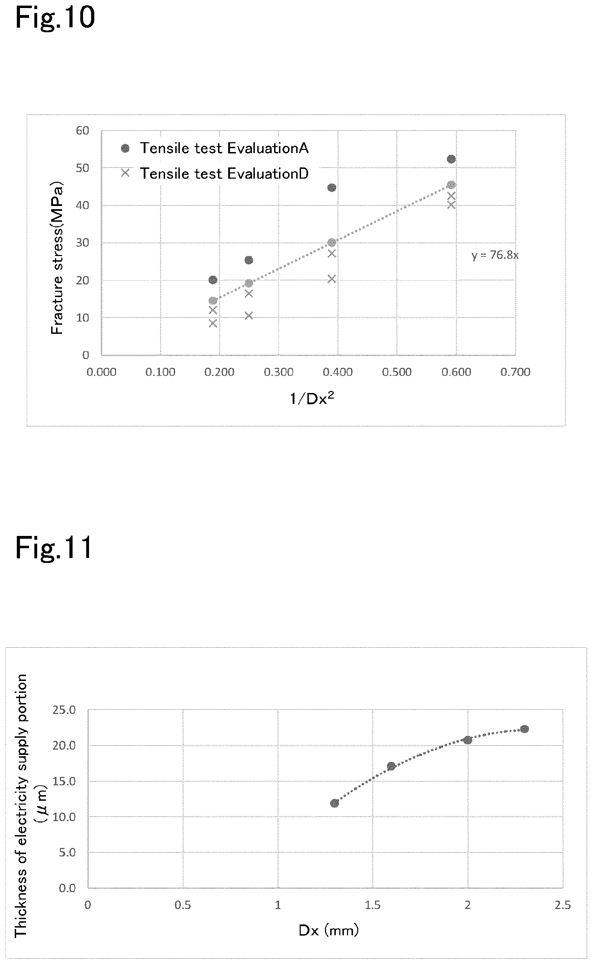

FIG. 10 is a graph showing relationships between the reciprocal of the square of the thickness of the glass plate and fracture strength extracted from Table 3, and further shows the results of the tensile test. As shown in FIG. 10, a relational expression $y=76.8x$, where $x$ is the reciprocal of the square of the thickness Dx of the glass plate and y is fracture strength (H), was considered as a limit of whether or not the electricity supply portion peeled away in the tensile test. That is, it was found that, when Formula (1) above is satisfied, it is possible to suppress peeling of the electricity supply portion from the glass plate.

Moreover, Formula (2) above can be derived from Formula (1) and Formula (5). That is, the relationship between the thickness of the electricity supply portion and the glass plate can be defined. FIG. 11 illustrates Formula (2). Note that, in the above-mentioned examples, a silver paste that contains metal microparticles in an amount of 95% after firing was used, but the relationships of the above-mentioned formulae are satisfied even when a silver paste contains metal microparticles in an amount of 95% or less after firing. This is true. The reason for this is that, when the content of metal microparticles is reduced, the amount of metal that controls the thermal expansion coefficient is reduced, and thus the thermal expansion coefficient tends to decrease. The same applies to cases where metal microparticles other than silver microparticles are used. The reason for this is that, for example, the thermal expansion coefficient of silver is higher than that of copper.

8. Modified Examples

8-1
The wiring pattern of the heating body 6 is not limited to that shown in the embodiment above, and various patterns can be employed. For example, the number of the main portions 611 and 621 of the first and second heating wires 61 and 62, the number of the coupling portions 612 and 622, the orientations of the main portions 611 and 621, the lengths of the connection wires 63, the orientations of the connection wires 63, the positions of the electricity supply portions 64 and 65, and the like can be changed as appropriate. Moreover, although the two heating wires 61 and 62 are connected in parallel in the embodiment above, three or more heating wires may also be connected in parallel. Alternatively, a single heating wire may also be connected to the electricity supply portions 64 and 65 in series. Furthermore, the heating wires 61 and 62 and the connection wires 63 may have the same wire width. For example, the sizes of the coupling portions 612 and 622 of the heating wires 61 and 62, and the connection wires 63 can also be made larger than the main portions 611 and 621. This makes it possible to reduce an amount of heat generated by portions that do not contribute to heating of the imaging window 113.

Moreover, the shape of the imaging window 113 need not be a trapezoidal shape, and can be changed as appropriate as long as images can be taken by the imaging device 2. If the shape of the imaging window is changed, the wiring pattern of the heating body 6 can be changed as appropriate.

8-2
Although portions of the heating body 6 (the electricity supply portions 64 and 65, connection wires 63, and the coupling portions 612 and 622) are disposed on the mask layer 110 in the embodiment above, they can also be disposed directly on the inner glass plate 12.

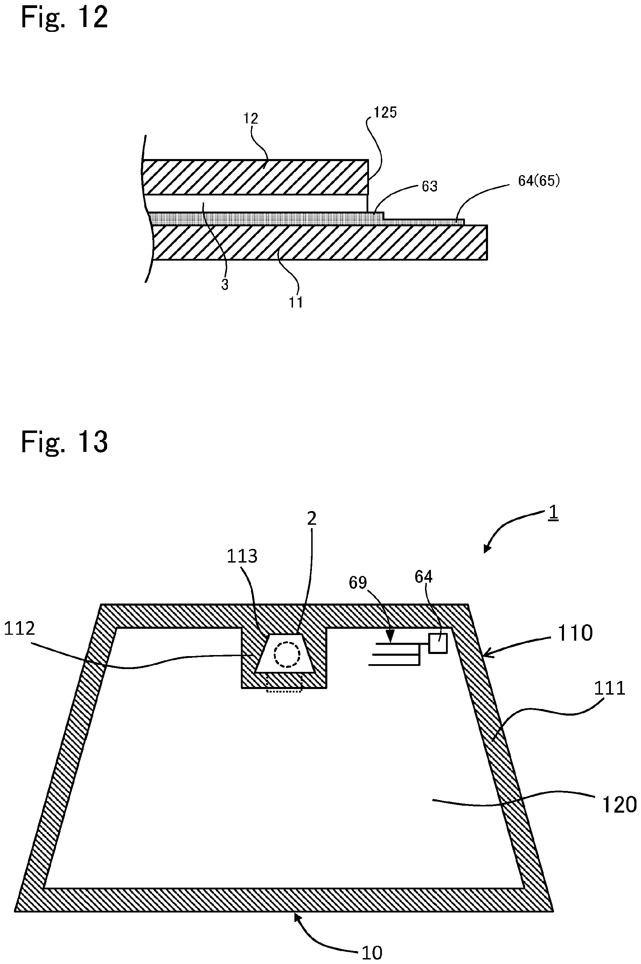

8-3
The heating body 6 can also be disposed on the surface on the vehicle interior side of the outer glass plate 11 as shown in FIG. 12. In this case, a cutout 125 is formed at an end portion of the inner glass plate 12, and the outer glass plate 11 is exposed to the outside from this cutout 125. If the electricity supply portion 6 is disposed on this exposed portion, a terminal is easily attached thereto.

8-4
A portion or the entirety of the mask layer 110 may be constituted by a blocking film that is attachable to the laminated glass 10, and the field of view from the outside of the vehicle may be blocked by the blocking film. Note that, if the blocking film is attached to a surface on the vehicle exterior side of the inner glass plate 12, the blocking film can be attached before preliminary bonding or after permanent bonding.

Also, from the viewpoint of preventing a path of light in the laminated glass 10 from fogging up, the mask layer 110 is not necessarily required, and it is sufficient that the heating wires 6 and the antifog sheet 7 are attached to a region (the imaging window: information acquisition region) through which light passes.

8-5
Although the present invention is applied to the heating wire for heating the imaging window 113 in the embodiment above, the present invention can be applied to a heating wire of a heater for heating a glass plate, such as a deicer provided on a windshield or a defogger provided on the rear glass. When the heating wire is used as a heating wire for a deicer, it is possible to form a mask layer on a surface on the vehicle interior side of the outer glass plate 11 of the laminated glass, and form a heating wire for a deicer on this mask layer. In this case, the inner glass plate 12 can be configured to be provided with no mask layer. Note that the heating wires etc. 61 to 63 can be disposed on a glass plate constituted by a single plate instead of a laminated glass.

8-6

Although the heating wires 61 and 62 (and the connection wires 63) are caused to generate heat by supplying electric power to the electricity supply portions 64 and 65 in the embodiment above, an electrical element such as a light-control element or a breakage detecting element can be used as an electric power supply target instead of the heating wires etc. 61 to 63. When such an electrical element is used, a connection member having a configuration similar to those of the heating wires etc. 61 to 63 is disposed on the glass plate 1 or the mask layer 110, and the electricity supply portion and the electrical element are connected to each other via this connection member. Accordingly, the specifications of the connection member, such as the dimensions, can be set to be the same as those of the above-described heating wires.

8-7

When an antenna conductor that receives electric power is disposed, the antenna conductor can be configured in the same manner as the heating wires. For example, as shown in FIG. 13, it is possible to dispose an antenna conductor 69 on a surface on the vehicle interior side of the inner glass plate 12 or outer glass plate 11 (or on the mask layer 110), and to connect the antenna conductor 69 to the electricity supply portion 64. The electricity supply portion 64 can be disposed on any of the glass plates 11 and 12 and the mask layer 110 formed on one of the glass plates 11 and 12. The antenna conductor 69 is constituted by a thread member formed using the same method (e.g., screen printing) as the method of forming the heating wires 61 and 62, and is thinner than the electricity supply portions 64 and 65. Also, the configuration of the electricity supply portion 64 is the same as that of the embodiment above. Note that the shape of the antenna conductor 69 shown in FIG. 13 is merely an example, and the antenna conductor 69 can be configured as appropriate by varying the antenna pattern to be used for various media such as AM, FM, a digital television, and DAB. The terminal 8 is fixed to the electricity supply portion 64 via the solder 7, and a conductive cable connected to this terminal 8 is connected to a receiver for various media via an amplifier. As described above, even when an antenna is provided, it is possible to suppress a decrease in the fracture strength of the glass plate 11 or 12 at the position where the electricity supply portion 64 is provided, as in the case of the embodiment above.

8-8

In order to reduce the thicknesses of the electricity supply portions 64 and 65, a silver paste for forming the electricity supply portion can be, for example, diluted using a solvent and used. In this case, after the silver paste has been applied, the solvent evaporates by drying, and thus the thickness of silver after drying, namely the thicknesses of the electricity supply portions 64 and 65, can be reduced.

8-9

Although electric power is supplied to the electricity supply portions 64 and 65 by fixing the connection terminals 8 to the electricity supply portions 64 and 65 using the solder 7 and connecting the conductive cables 9 to the connection terminals 8 in the embodiment above, wires such as conductive wires of the conductive cables 9 can also be fixed directly to the electricity supply portions 64 and 65 via the solder 7. The same applies to the above-described case where an antenna or electrical element is connected to the electricity supply portion.

8-10

Although the imaging device 2 that has a camera is used as the information acquisition device of the present invention in the embodiment above, there is no limitation to this configuration, and various information acquisition devices can be used. That is, there is no limitation as long as the information acquisition device emits and/or receives light in order to acquire information from the outside of the vehicle. Various devices can be used such as a light receiving device for receiving signals from the outside of the vehicle that are emitted by a laser radar, a light sensor, a rain sensor, an optical beacon, or the like. Also, an opening such as the above-mentioned imaging window 113 can be provided in the mask layer 110 as appropriate according to the type of light, and it is also possible to provide a plurality of openings. For example, if a stereo camera is provided, the mask layer 110 is provided with two imaging windows, and a heating wire is disposed on each imaging window 113. Note that an information acquisition device may be in contact or need not be in contact with glass. Also, the entire periphery of the imaging window 113 need not be closed, and may have a shape in which a portion thereof is open.

LIST OF REFERENCE NUMERALS

| 1 | Laminated glass |
| 11 | Outer glass plate |
| 12 | Inner glass plate |
| 3 | Interlayer |
| 110 | Mask layer |

113         Imaging window (opening)
61 to 63    Heating wire
64, 65      Electricity supply portion

**Claims**

**1.** A glass plate module to which a wire (9) for supplying electric power is capable of being joined, comprising:

a glass plate (10);
a heating wire (61, 62, 63) disposed on the glass plate (10); and
an electricity supply portion (64, 65) disposed on the glass plate (10), the wire (9) being connected to the electricity supply portion (64, 65), and the electricity supply portion (64, 65) supplying electric power to the heating wire (61, 62, 63),
wherein the heating wire (61, 62, 63) is formed using a conductive print that contains, as a main component, the same metal microparticles as those contained in the electricity supply portion (64, 65),
the electricity supply portion (64, 65) is formed using conductive print that contains, as a main component, metal microparticles whose thermal expansion coefficient is larger than that of the glass plate (10), and
the electricity supply portion (64, 65) is thinner than the heating wire (61, 62, 63).

**2.** The glass plate module according to claim 1,
wherein the heating wire (61, 62, 63) has a width of 0.2 mm or more and 3.0 mm or less.

**3.** The glass plate module according to claim 2,
wherein the electricity supply portion (64, 65) is wider than the heating wire (61, 62, 63), and when a thickness of the electricity supply portion (64, 65) is defined as D1 and a thickness of the heating wire (61, 62, 63) is defined as D2, a relationship $0.4 \leq D1/D2 \leq 0.9$ is satisfied.

**4.** The glass plate module according to any one of claims 1 to 3,
wherein the heating wire (61, 62, 63) is a heating wire for a camera window or a heating wire (61, 62, 63) for a deicer that is disposed in a region of the glass plate (10) through which a camera takes images.

**5.** The glass plate module according to any one of claims 1 to 4, further comprising:

solder (7) disposed on the electricity supply portion (64, 65); and
a terminal (8) fixed to the electricity supply portion (64, 65) via the solder (7).

**6.** The glass plate module according to any one of claims 1 to 4, further comprising:

solder (7) disposed on the electricity supply portion (64, 65); and
the wire (9) fixed to the electricity supply portion (64, 65) via the solder (7).

**7.** The glass plate module according to any one of claims 1 to 6,
wherein the glass plate (10) is made of clear glass, heat-ray absorbing glass, or soda-lime based glass.

**8.** The glass plate module according to claim 7,
wherein, when a thickness of the glass plate (10) on which the electricity supply portion (64, 65) is formed is defined as Dx, fracture strength H of the electricity supply portion (64, 65) on the glass plate (10) satisfies a formula below:

$$H \geq 76.8/Dx^2.$$

**9.** The glass plate module according to claim 8,
wherein, when a thickness of the electricity supply portion (64, 65) is defined as D1, a formula below is satisfied:

$$D1 \leq (81.4-(76.8/Dx^2))/3.0.$$

10. The glass plate module according to any one of claims 1 to 9, further comprising a mask layer (110) layered on the glass plate (10),
    wherein the electricity supply portion (64, 65) is disposed on the mask layer (110).

11. The glass plate module according to any one of claims 1 to 10,
    wherein the glass plate (10) is not made of tempered glass.

12. The glass plate module according to any one of claims 1 to 11,
    wherein the glass plate (10) is constituted by laminated glass that includes an outer glass plate (11), an inner glass plate (12), and an interlayer (13) disposed between the outer glass plate (11) and the inner glass plate (12).

13. The glass plate module according to claim 12,

    wherein the inner glass plate (12) is provided with a cutout (125), and
    the electricity supply portion (64, 65) is disposed on an exposed surface of the outer glass plate (11) that is exposed to the outside from the cutout (125).

14. The glass plate module according to claim 13,
    wherein the electricity supply portion (64, 65) is disposed on the inner glass plate (12).

**Patentansprüche**

1. Glasplattenmodul, mit dem eine Leitung (9) zum Einspeisen von elektrischer Leistung geeignet ist, verbunden zu sein, Folgendes umfassend:

    eine Glasplatte (10);
    einen Heizdraht (61, 62, 63), der auf der Glasplatte (10) angeordnet ist; und
    einen Elektrizitätseinspeisungsabschnitt (64, 65), der auf der Glasplatte (10) angeordnet ist, wobei die Leitung (9) mit dem Elektrizitätseinspeisungsabschnitt (64, 65) verbunden ist und der Elektrizitätseinspeisungsabschnitt (64, 65) den Heizdraht (61, 62, 63) mit elektrischer Leistung speist,
    wobei der Heizdraht (61, 62, 63) unter Verwendung eines leitfähigen Aufdrucks ausgebildet ist, der als eine Hauptkomponente die gleichen Metallmikroteilchen wie jene, die im Elektrizitätseinspeisungsabschnitt (64, 65) enthalten sind, enthält,
    wobei der Elektrizitätseinspeisungsabschnitt (64, 65) unter Verwendung eines leitfähigen Aufdrucks ausgebildet ist, der als eine Hauptkomponente Metallmikroteilchen enthält, deren Wärmeausdehnungskoeffizient größer ist als jener der Glasplatte (10) und
    wobei der Elektrizitätseinspeisungsabschnitt (64, 65) dünner als der Heizdraht (61, 62, 63) ist.

2. Glasplattenmodul nach Anspruch 1,
    wobei der Heizdraht (61, 62, 63) eine Breite von 0,2 mm oder mehr und 3,0 mm oder weniger aufweist.

3. Glasplattenmodul nach Anspruch 2,
    wobei der Elektrizitätseinspeisungsabschnitt (64, 65) breiter ist als der Heizdraht (61, 62, 63) und, wenn die Dicke des Elektrizitätseinspeisungsabschnitts (64, 65) als D1 definiert ist und die Dicke des Heizdrahts (61, 62, 63) als D2 definiert ist, eine Beziehung $0,4 \leq D1/D2 \leq 0,9$ erfüllt ist.

4. Glasplattenmodul nach einem der Ansprüche 1 bis 3,
    wobei der Heizdraht (61, 62, 63) ein Heizdraht für ein Kamerafenster oder ein Heizdraht (61, 62, 63) für eine Enteisungseinheit ist, die in einem Bereich der Glasplatte (10) angeordnet ist, durch den hindurch eine Kamera Bilder aufnimmt.

5. Glasplattenmodul nach einem der Ansprüche 1 bis 4, ferner umfassend:

    ein Lötmittel (7), das auf dem Elektrizitätseinspeisungsabschnitt (64, 65) angeordnet ist; und
    einen Anschluss (8), der über das Lötmittel (7) auf dem Elektrizitätseinspeisungsabschnitt (64, 65) fixiert ist.

6. Glasplattenmodul nach einem der Ansprüche 1 bis 4, ferner umfassend:

ein Lötmittel (7), das auf dem Elektrizitätseinspeisungsabschnitt (64, 65) angeordnet ist; und
wobei die Leitung (9) über das Lötmittel (7) auf dem Elektrizitätseinspeisungsabschnitt (64, 65) fixiert ist.

7. Glasplattenmodul nach einem der Ansprüche 1 bis 6,
wobei die Glasplatte (10) aus Klarglas, Hitzestrahl-absorbierendem Glas oder Kalknatronglas besteht.

8. Glasplattenmodul nach Anspruch 7,
wobei, wenn die Dicke der Glasplatte (10), auf der der Elektrizitätseinspeisungsabschnitt (64, 65) ausgebildet ist, als Dx definiert ist, die Bruchfestigkeit H des Elektrizitätseinspeisungsabschnitts (64, 65) auf der Glasplatte (10) die nachstehende Formel erfüllt:

$$H \geq 76{,}8/Dx^2.$$

9. Glasplattenmodul nach Anspruch 8,
wobei, wenn die Dicke des Elektrizitätseinspeisungsabschnitts (64, 65) als D1 definiert ist, die nachstehende Formel erfüllt ist:

$$D1 \leq (81{,}4-(76{,}8/Dx^2))/3{,}0.$$

10. Glasplattenmodul nach einem der Ansprüche 1 bis 9, ferner umfassend eine Maskenschicht (110), die auf der Glasplatte (10) aufgeschichtet ist,
wobei der Elektrizitätseinspeisungsabschnitt (64, 65) auf der Maskenschicht (110) angeordnet ist.

11. Glasplattenmodul nach einem der Ansprüche 1 bis 10,
wobei die Glasplatte (10) nicht aus Hartglas besteht.

12. Glasplattenmodul nach einem der Ansprüche 1 bis 11,
wobei die Glasplatte (10) aus laminiertem Glas besteht, das eine äußere Glasplatte (11), eine innere Glasplatte (12) und eine Zwischenschicht (13), die zwischen der äußeren Glasplatte (11) und der inneren Glasplatte (12) angeordnet ist, umfasst.

13. Glasplattenmodul nach Anspruch 12,

wobei die innere Glasplatte (12) mit einer Aussparung (125) bereitgestellt ist, und
wobei der Elektrizitätseinspeisungsabschnitt (64, 65) auf einer freiliegenden Oberfläche der äußeren Glasplatte (11) angeordnet ist, die von der Aussparung (125) nach Außen freiliegend ist.

14. Glasplattenmodul nach Anspruch 13,
wobei der Elektrizitätseinspeisungsabschnitt (64, 65) auf der inneren Glasplatte (12) angeordnet ist.


**Revendications**

1. Module de plaque de verre auquel un fil (9) pour fournir de l'énergie électrique peut être relié, comprenant :

une plaque de verre (10),
un fil chauffant (61, 62, 63) disposé sur la plaque de verre (10) ; et
une partie de fourniture d'électricité (64, 65) disposée sur la plaque de verre (10), le fil (9) étant connecté à la partie de fourniture d'électricité (64, 65), et la partie de fourniture d'électricité (64, 65) fournissant de l'énergie électrique au fil chauffant (61, 62, 63),
dans lequel le fil chauffant (61, 62, 63) est formé en utilisant une impression conductrice qui contient, en tant que composant principal, les mêmes microparticules métalliques que celles contenues dans la partie de fourniture d'électricité (64, 65),
la partie de fourniture d'électricité (64, 65) est formée en utilisant une impression conductrice qui contient, en tant que composant principal, des microparticules métalliques dont le coefficient de dilatation thermique est supérieur à celui de la plaque de verre (10), et

la partie de fourniture d'électricité (64, 65) est plus mince que le fil chauffant (61, 62, 63).

2. Module de plaque de verre selon la revendication 1,
dans lequel le fil chauffant (61, 62, 63) présente une largeur de 0,2 mm ou plus et de 3,0 mm ou moins.

3. Module de plaque de verre selon la revendication 2,
dans lequel la partie de fourniture d'électricité (64, 65) est plus large que le fil chauffant (61, 62, 63), et lorsqu'une épaisseur de la partie de fourniture d'électricité (64, 65) est définie comme étant D1 et qu'une épaisseur du fil chauffant (61, 62, 63) est définie comme étant D2, une relation 0,4 ≤ D1/D2 ≤ 0,9 est satisfaite.

4. Module de plaque de verre selon l'une quelconque des revendications 1 à 3,
dans lequel le fil chauffant (61, 62, 63) est un fil chauffant pour une fenêtre de caméra ou un fil chauffant (61, 62, 63) pour un dégivreur qui est disposé dans une région de la plaque de verre (10) à travers laquelle une caméra prend des images.

5. Module de plaque de verre selon l'une quelconque des revendications 1 à 4, comprenant en outre :

une soudure (7) disposée sur la partie de fourniture d'électricité (64, 65) ; et
une borne (8) fixée à la partie de fourniture d'électricité (64, 65) via la soudure (7).

6. Module de plaque de verre selon l'une quelconque des revendications 1 à 4, comprenant en outre :

une soudure (7) disposée sur la partie de fourniture d'électricité (64, 65) ; et
le fil (9) fixé à la partie de fourniture d'électricité (64, 65) via la soudure (7).

7. Module de plaque de verre selon l'une quelconque des revendications 1 à 6,
dans lequel la plaque de verre (10) est réalisée en verre transparent, en verre absorbant les rayons thermiques ou en verre à base de chaux sodée.

8. Module de plaque de verre selon la revendication 7,
dans lequel, lorsqu'une épaisseur de la plaque de verre (10) sur laquelle la partie de fourniture d'électricité (64, 65) est formée est définie comme étant Dx, la résistance à la rupture H de la partie de fourniture d'électricité (64, 65) sur la plaque de verre (10) satisfait à une formule ci-dessous :

$$H \geq 76,8/Dx^2.$$

9. Module de plaque de verre selon la revendication 8,
dans lequel, lorsqu'une épaisseur de la partie de fourniture d'électricité (64, 65) est définie comme étant D1, une formule ci-dessous est satisfaite :

$$D1 \leq (81,4-(76,8/Dx^2))/3,0.$$

10. Module de plaque de verre selon l'une quelconque des revendications 1 à 9, comprenant en outre une couche de masque (110) déposée sur la plaque de verre (10),
dans lequel la partie de fourniture d'électricité (64, 65) est disposée sur la couche de masque (110).

11. Module de plaque de verre selon l'une quelconque des revendications 1 à 10,
dans lequel la plaque de verre (10) n'est pas réalisée en verre trempé.

12. Module de plaque de verre selon l'une quelconque des revendications 1 à 11,
dans lequel la plaque de verre (10) est constituée de verre feuilleté qui inclut une plaque de verre extérieure (11), une plaque de verre intérieure (12) et une couche intermédiaire (13) disposée entre la plaque de verre extérieure (11) et la plaque de verre intérieure (12).

13. Module de plaque de verre selon la revendication 12,

dans lequel la plaque de verre intérieure (12) est pourvue d'une découpe (125), et
la partie de fourniture d'électricité (64, 65) est disposée sur une surface exposée de la plaque de verre extérieure
(11) qui est exposée à l'extérieur depuis la découpe (125).

14. Module de plaque de verre selon la revendication 13,
dans lequel la partie de fourniture d'électricité (64, 65) est disposée sur la plaque de verre intérieure (12).

Fig. 1

Fig. 2

Vehicle exterior side

Vehicle interior side

112

2

3

11

112

113

10

12

3

# Fig. 3

# Fig. 4

Fig. 5

Fig. 6

Fig. 7

Fig. 8

Fig. 9

Fig.10

Fig.11

## Fig. 12

## Fig. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014519149 A
- US 20170041987 A1
- US 20140008347 A1